(19) Europäisches Patentamt / European Patent Office / Office européen des brevets

(11) **EP 4 464 414 A1**

(12) **EUROPEAN PATENT APPLICATION**

(43) Date of publication:
**20.11.2024 Bulletin 2024/47**

(21) Application number: **24170791.8**

(22) Date of filing: **17.04.2024**

(51) International Patent Classification (IPC):
**B01L 3/02** (2006.01)

(52) Cooperative Patent Classification (CPC):
**B01L 3/0268; B01L 2200/061; B01L 2300/0645; B01L 2300/0829**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **16.05.2023 JP 2023080918**

(71) Applicant: **Funai Electric Co., Ltd.**
**Daito,**
**Osaka, 574-0013 (JP)**

(72) Inventor: **TANABE, Hideki**
**Daito, Osaka, 574-0013 (JP)**

(74) Representative: **Kurig, Thomas**
**Becker Kurig & Partner**
**Patentanwälte mbB**
**Bavariastraße 7**
**80336 München (DE)**

(54) **DROPLET DISPENSING DEVICE, SENSOR PLATE, AND DROPLET DETECTION METHOD**

(57) A droplet dispensing device capable of accurately dispensing droplets is provided. A droplet dispensing device (2) includes a head part (26) discharging droplets, and a sensor plate (12) disposed between the head part (26) and a well plate (10), the sensor plate (12) having a plurality of opening parts (42) formed respectively corresponding to a plurality of wells (24) and a plurality of electrostatic capacitance sensors (46) each disposed at a circumferential edge of the plurality of opening parts (42).

FIG. 7

EP 4 464 414 A1

**Description**

BACKGROUND

Technical Field

The disclosure relates to a droplet dispensing device dispensing droplets to a well plate, a sensor plate, and the droplet detection method.

Description of Related Art

A droplet dispensing device dispensing droplets of a sample, a specimen, or the like to a well plate is known (for example, refer to Patent Document 1). In this droplet dispensing device, a predetermined amount of droplets is discharged from an inkjet head toward each of a plurality of wells formed on an upper surface of the well plate.
[Patent Document 1] Japanese Patent Laid-Open No. 2005-283150

SUMMARY

In the droplet dispensing device in the related art described above, when clogging has occurred in a nozzle of an inkjet head, there is a problem that a predetermined amount of droplets cannot be accurately dispensed into each of a plurality of wells.
The disclosure provides a droplet dispensing device capable of accurately dispensing droplets, a sensor plate, and a droplet detection method.
A droplet dispensing device according to a first aspect of the disclosure is a droplet dispensing device for dispensing droplets to a well plate having a plurality of wells formed on a main surface thereof. The droplet dispensing device includes a discharge part discharging droplets toward one or more wells of the plurality of wells, and a sensor plate disposed between the discharge part and the well plate, the sensor plate having a plurality of opening parts formed respectively corresponding to the plurality of wells and a plurality of electrostatic capacitance sensors each disposed at a circumferential edge of the plurality of opening parts.
According to the present aspect, the plurality of electrostatic capacitance sensors are each disposed at the circumferential edge of each of the plurality of opening parts of the sensor plate. Accordingly, each of the plurality of electrostatic capacitance sensors can detect droplets from the discharge part having passed through the opening part on the basis of change in electrostatic capacitance caused by the droplets which have passed through the opening part corresponding to the electrostatic capacitance sensor. Accordingly, for example, on the basis of detection results of the electrostatic capacitance sensors, it is possible to determine whether a predetermined amount of droplets has passed through the opening part. When the discharging amount of droplets does not reach the predetermined amount due to clogging or the like of the discharge part, processing such as discharging droplets corresponding to an amount of shortage from the discharge part can be executed. As a result, droplets can be accurately dispensed to the well plate.
For example, in the droplet dispensing device according to a second aspect of the disclosure, in the first aspect, each of the plurality of electrostatic capacitance sensors may be constituted to detect droplets from the discharge part having passed through an opening part on the basis of change in electrostatic capacitance caused by the droplets which have passed through the opening part, of the plurality of opening parts, corresponding to the electrostatic capacitance sensor.
According to the present aspect, each of the plurality of electrostatic capacitance sensors can accurately detect droplets which have passed through the opening part corresponding to the electrostatic capacitance sensor.
For example, in the droplet dispensing device according to a third aspect of the disclosure, in the second aspect, each of the plurality of electrostatic capacitance sensors may be constituted to output an electrical signal changing in response to the change in electrostatic capacitance. The droplet dispensing device may be constituted to further include a determination part determining whether a predetermined amount of droplets has passed through a particular opening part of the plurality of opening parts corresponding to a particular electrostatic capacitance sensor of the plurality of electrostatic capacitance sensors on the basis of an electrical signal from the particular electrostatic capacitance sensor.
According to the present aspect, the determination part can easily determine whether a predetermined amount of droplets has passed through the particular opening part corresponding to the particular electrostatic capacitance sensor on the basis of an electrical signal from the particular electrostatic capacitance sensor.
For example, in the droplet dispensing device according to a fourth aspect of the disclosure, in the third aspect, the determination part may be constituted to determine whether the predetermined amount of droplets has passed through the particular opening part by calculating a difference between a value of an electrical signal from the particular electrostatic capacitance sensor in a state before the discharge part discharges droplets and a value of an electrical signal from the particular electrostatic capacitance sensor in a state where the discharge part is discharging droplets, and comparing an integral value obtained by integrating the difference with respect to time with a first threshold.

According to the present aspect, the determination part can easily determine whether a predetermined amount of droplets has passed through the particular opening part by comparing the integral value and the first threshold.

For example, in the droplet dispensing device according to a fifth aspect of the disclosure, in the third aspect or the fourth aspect, the droplet dispensing device may be constituted to further include a converter performing analog-digital conversion of an electrical signal from each of the plurality of electrostatic capacitance sensors. The determination part may be constituted to determine whether the predetermined amount of droplets has passed through the particular opening part on the basis of an electrical signal from the particular electrostatic capacitance sensor subjected to analog-digital conversion by the converter.

According to the present aspect, the determination part can easily perform arithmetic processing for determining whether a predetermined amount of droplets has passed through the particular opening part on the basis of an electrical signal from the particular electrostatic capacitance sensor subjected to analog-digital conversion by the converter.

For example, in the droplet dispensing device according to a sixth aspect of the disclosure, in the third aspect or the fourth aspect, the droplet dispensing device may be constituted to further include a converter accumulating an electrical signal from each of the plurality of electrostatic capacitance sensors as an analog electrical signal. The determination part may be constituted to determine whether the predetermined amount of droplets has passed through the particular opening part on the basis of an electrical signal from the particular electrostatic capacitance sensor accumulated by the converter.

According to the present aspect, the determination part can determine with a high sensitivity whether a predetermined amount of droplets has passed through the particular opening part on the basis of an electrical signal from the particular electrostatic capacitance sensor accumulated by the converter.

For example, in the droplet dispensing device according to a seventh aspect of the disclosure, in any one aspect of the third aspect to the sixth aspect, the determination part may be constituted to further control the discharge part such that droplets corresponding to an amount of shortage are discharged through the particular opening part when it is determined that the predetermined amount of droplets has not passed through the particular opening part.

According to the present aspect, even when a predetermined amount of droplets has not passed through the particular opening part, droplets can be accurately dispensed to the well plate by discharging droplets corresponding to the amount of shortage through the particular opening part.

For example, in the droplet dispensing device according to an eighth aspect of the disclosure, in any one aspect of the third aspect to the seventh aspect, the droplet dispensing device may be constituted to further include a notification part issuing a notification for prompting a user to perform maintenance of the sensor plate when a value of an electrical signal from the particular electrostatic capacitance sensor in a state before the discharge part discharges droplets exceeds a second threshold.

According to the present aspect, when a value of an electrical signal from the particular electrostatic capacitance sensor in a state before the discharge part discharges droplets exceeds the second threshold, there is a probability that droplets will have adhered to the sensor plate. In such a case, the notification part can prompt a user to perform maintenance of the sensor plate by issuing a notification to a user.

For example, in the droplet dispensing device according to a ninth aspect of the disclosure, in any one aspect of the first aspect to the eighth aspect, the droplet dispensing device may be constituted to further include a drive circuit selectively driving a particular electrostatic capacitance sensor, of the plurality of electrostatic capacitance sensors, corresponding to a particular well when droplets from the discharge part are discharged to the particular well of the plurality of wells.

According to the present aspect, power saving of the drive circuit can be achieved.

For example, in the droplet dispensing device according to a tenth aspect of the disclosure, in any one aspect of the first aspect to the ninth aspect, the sensor plate may be constituted to be formed integrally with an upper surface of the well plate.

According to the present aspect, the well plate and the sensor plate can be easily attached and detached with respect to a tray or the like.

For example, in the droplet dispensing device according to an eleventh aspect of the disclosure, in any one aspect of the first aspect to the tenth aspect, the discharge part may be constituted to include a plurality of nozzles disposed side by side in a predetermined direction. Each of the plurality of opening parts may be constituted to be formed in a rectangular shape having a first side and a second side extending substantially parallel to the predetermined direction and facing each other, and a third side and a fourth side extending substantially perpendicular to the predetermined direction and facing each other. Each of the plurality of electrostatic capacitance sensors may be constituted to include a first electrode disposed in a region corresponding to the first side at the circumferential edge of the opening part corresponding to the electrostatic capacitance sensor, and a second electrode disposed in a region corresponding to the second side at the circumferential edge of the opening part corresponding to the electrostatic capacitance sensor.

According to the present aspect, the sensitivity of each of the electrostatic capacitance sensors can be enhanced.

For example, in the droplet dispensing device according to a twelfth aspect of the disclosure, in any one aspect of the first aspect to the tenth aspect, each of the plurality of opening parts may be constituted to be formed in a circular shape. Each of the plurality of electrostatic capacitance sensors may be constituted to include a first electrode disposed in an arc shape along the circumferential edge of the opening part corresponding to the electrostatic capacitance sensor, and a second electrode disposed in an arc shape along the circumferential edge of the opening part corresponding to the electrostatic capacitance sensor and disposed at a position substantially symmetrical to the first electrode with respect to a center of a diameter of the opening part.

According to the present aspect, the sensitivity of each of the electrostatic capacitance sensors can be enhanced.

For example, in the droplet dispensing device according to a thirteenth aspect of the disclosure, in any one aspect of the first aspect to the tenth aspect, each of the plurality of opening parts may be constituted to be formed in a circular shape or a rectangular shape. Each of the plurality of electrostatic capacitance sensors may be constituted to include a first electrode disposed at the circumferential edge of the opening part corresponding to the electrostatic capacitance sensor on a first main surface of the sensor plate, and a second electrode disposed at the circumferential edge of the opening part corresponding to the electrostatic capacitance sensor on a second main surface on a side opposite to the first main surface of the sensor plate.

According to the present aspect, the sensor plate can be easily produced.

In addition, a sensor plate according to a fourteenth aspect of the disclosure is a sensor plate used in a droplet dispensing device having a discharge part discharging droplets toward a well plate having a plurality of wells formed on a main surface thereof. The sensor plate includes a plate main body disposed between the discharge part and the well plate and having a plurality of opening parts formed respectively corresponding to the plurality of wells, and a plurality of electrostatic capacitance sensors each disposed at a circumferential edge of the plurality of opening parts.

According to the present aspect, similar to those described above, droplets can be accurately dispensed to the well plate.

In addition, a droplet detection method according to a fifteenth aspect of the disclosure is a droplet detection method in a droplet dispensing device for dispensing droplets to a well plate having a plurality of wells formed on a main surface thereof. The droplet dispensing device includes a discharge part discharging droplets toward one or more wells of the plurality of wells, and a sensor plate disposed between the discharge part and the well plate, the sensor plate having a plurality of opening parts formed respectively corresponding to the plurality of wells and a plurality of electrostatic capacitance sensors each disposed at a circumferential edge of the plurality of opening parts. In the droplet detection method, droplets from the discharge part having passed through an opening part are detected using each of the plurality of electrostatic capacitance sensors on the basis of change in electrostatic capacitance caused by the droplets which have passed through the opening part, of the plurality of opening parts, corresponding to the electrostatic capacitance sensor.

According to the present aspect, droplets from the discharge part having passed through an opening part are detected using each of the plurality of electrostatic capacitance sensors on the basis of change in electrostatic capacitance caused by the droplets which have passed through the opening part corresponding to the electrostatic capacitance sensor. Accordingly, for example, on the basis of detection results of the electrostatic capacitance sensors, it is possible to determine whether a predetermined amount of droplets has passed through the opening part. When the discharging amount of droplets does not reach the predetermined amount due to clogging or the like of the discharge part, processing such as discharging droplets corresponding to an amount of shortage from the discharge part can be executed. As a result, droplets can be accurately dispensed to the well plate.

According to the droplet dispensing device or the like according to the aspect of the disclosure, droplets can be accurately dispensed.

BRIEF DESCRIPTION OF THE DRAWINGS

FIG. 1 is a perspective view showing an external appearance of a droplet dispensing device according to Embodiment 1.

FIG. 2 is a perspective view showing an internal structure of the droplet dispensing device according to Embodiment 1.

FIG. 3 is an exploded perspective view showing a well plate and a sensor plate of the droplet dispensing device according to Embodiment 1.

FIG. 4 is a plan view showing the well plate of the droplet dispensing device according to Embodiment 1.

FIG. 5 is a plan view showing an upper surface side of the sensor plate of the droplet dispensing device according to Embodiment 1.

FIG. 6 is a plan view showing a lower surface side of the sensor plate of the droplet dispensing device according to Embodiment 1.

FIG. 7 is a cross-sectional view of a main part of the sensor plate according to Embodiment 1 along line VII-VII in FIG. 5.

FIG. 8 is a block diagram showing a functional constitution of the droplet dispensing device according to Embodiment 1.

FIG. 9 is a graph showing an example of change over time in electrical signal according to Embodiment 1.

FIG. 10 is a flowchart showing a flow of operation of the droplet dispensing device according to Embodiment 1.

FIG. 11 is a view showing a sensor plate according to Embodiment 2.

FIG. 12 is a view showing a sensor plate according to Embodiment 3.

FIG. 13 is a view showing a sensor plate according to Embodiment 4.

DESCRIPTION OF THE EMBODIMENT

Hereinafter, embodiments of the disclosure will be described in detail using the drawings. The embodiments which will be described below are all inclusive or specific examples. Numerical values, shapes, materials, constituent elements, disposition positions and connection forms of the constituent elements, and the like described in the following embodiments are merely examples and are not intended to limit the disclosure. In addition, regarding the constituent elements in the following embodiments, constituent elements that are not mentioned in the independent claims will be described as arbitrary constituent elements.

(Embodiment 1)

[1. Overall constitution of droplet dispensing device]

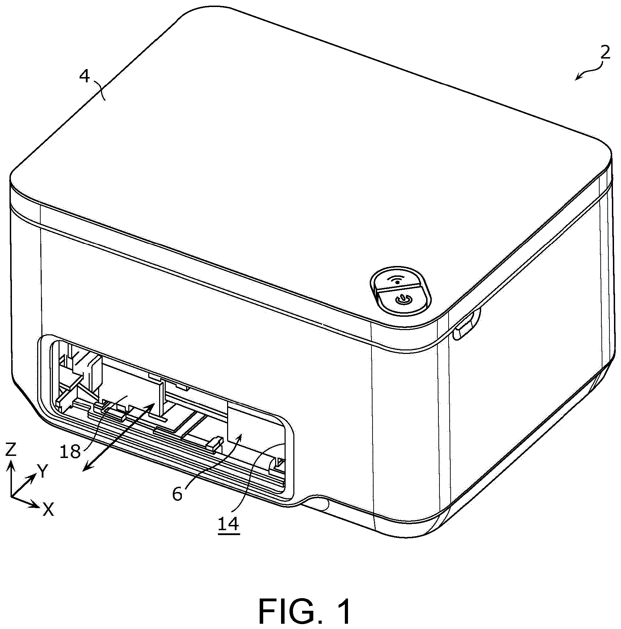

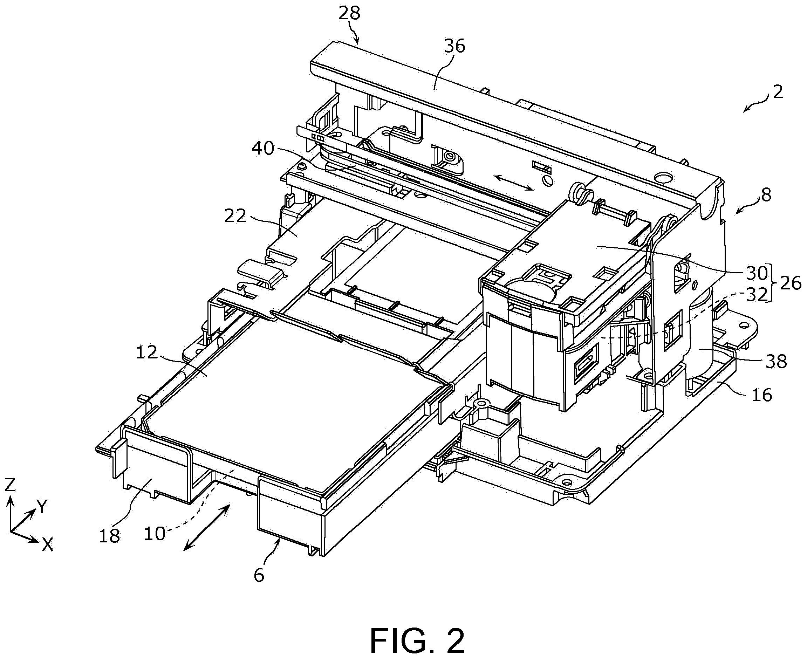

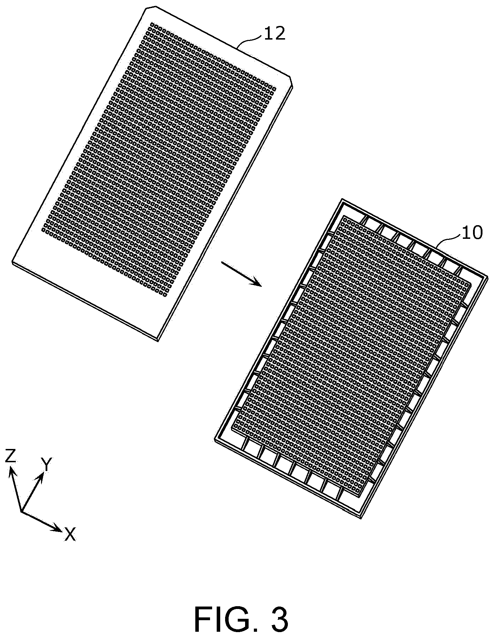

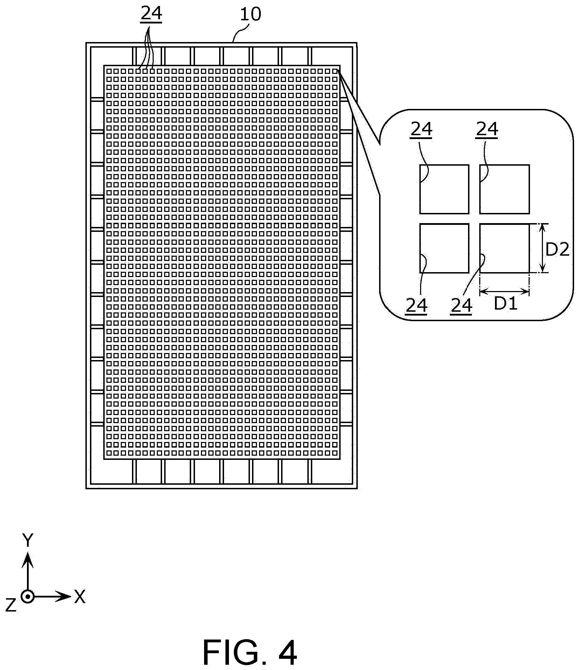

First, with reference to FIGS. 1 to 4, an overall constitution of a droplet dispensing device 2 according to Embodiment 1 will be described. FIG. 1 is a perspective view showing an external appearance of the droplet dispensing device 2 according to Embodiment 1. FIG. 2 is a perspective view showing an internal structure of the droplet dispensing device 2 according to Embodiment 1. FIG. 3 is an exploded perspective view showing a well plate 10 and a sensor plate 12 of the droplet dispensing device 2 according to Embodiment 1. FIG. 4 is a plan view showing the well plate 10 of the droplet dispensing device 2 according to Embodiment 1.

In FIGS. 1 to 4, a lateral direction of the droplet dispensing device 2 will be described as an X axis direction, a forward-rearward direction of the droplet dispensing device 2 will be described as a Y axis direction, and a vertical direction of the droplet dispensing device 2 will be described as a Z axis direction. In addition, the positive side in the X axis direction will be described as "the right side", the negative side in the X axis direction will be described as "the left side", the positive side in the Y axis direction will be described as "the rearward side", the negative side in the Y axis direction will be described as "the forward side", the positive side in the Z axis direction will be described as "the upward side", and the negative side in the Z axis direction will be described as "the downward side".

As shown in FIGS. 1 to 3, the droplet dispensing device 2 includes a housing 4, a tray unit 6, a discharge unit 8, the well plate 10, and the sensor plate 12. In the present embodiment, the droplet dispensing device 2 is a device for dispensing droplets to the well plate 10. For example, droplets are a reagent, a specimen, a sample, or the like in a liquid state used for a test and the like in the medical field and the physical chemistry field.

As shown in FIG. 1, the housing 4 is formed in a hollow box shape. An opening part 14 for inserting and drawing out the well plate 10 and the sensor plate 12 therethrough is formed on a front surface of the housing 4. In addition, as shown in FIG. 2, a base plate 16 for supporting each of components of the droplet dispensing device 2 is disposed inside the housing 4.

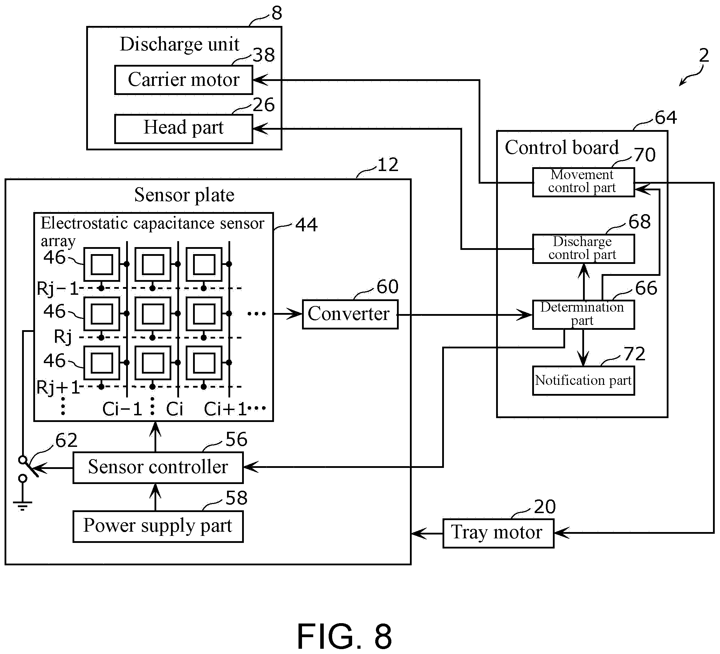

The tray unit 6 has a tray 18 and a tray motor 20 (refer to FIG. 8 which will be described below). For the sake of convenience of description, in FIG. 2, illustration of the tray motor 20 is omitted.

The tray 18 is provided such that the well plate 10 is detachably placed. The tray 18 is supported by a guide plate 22 disposed inside the housing 4 to be able to move in the forward-rearward direction (Y axis direction). Accordingly, the tray 18 can move in the forward-rearward direction along the guide plate 22 between a storage position (a position of the tray 18 shown in FIG. 1) where it is stored inside the housing 4 and a drawn-out position (a position of the tray 18 shown in FIG. 2) where at least a portion thereof is drawn out to a front side (the negative side in the Y axis direction) through the opening part 14 of the housing 4.

For example, the tray motor 20 is constituted of a servomotor and is supported by the base plate 16 inside the housing 4. The tray motor 20 moves the tray 18 relatively to a head part 26 (which will be described below) in the forward-rearward direction. Specifically, when a drive force of the tray motor 20 is transmitted to the tray 18 via a rack-and-pinion mechanism (not shown), the tray 18 moves between the storage position and the drawn-out position. In a state where the tray 18 is at the drawn-out position, the well plate 10 can be attached and detached with respect to the tray 18. Driving of the tray motor 20 is controlled by a control board 64 (refer to FIG. 8) disposed inside the housing 4. For the sake of convenience of description, in FIG. 2, illustration of the control board 64 is omitted.

For example, the well plate 10 is formed in substantially a rectangular flat plate shape in an XY-planar view and is detachably placed on an upper surface of the tray 18. As shown in FIG. 4, a plurality of wells 24 are disposed in a matrix shape on an upper surface (an example of a main surface) of the well plate 10. Each of the plurality of wells 24 is a recessed part for storing droplets discharged from the head part 26, and, for example, is formed in a rectangular shape in an XY-planar view. In a state where the tray 18 is at the storage position, the plurality of wells 24 of the well plate 10 are disposed below the head part 26. The number of wells 24 formed in one well plate 10 is 1,536 (=32×48), for example. In addition, in an XY-planar view, a transverse (X axis direction) length D1 of each of the wells 24 is 1.7 mm, for example, and a vertical (Y axis direction) length D2 of each of the wells 24 is 1.7 mm, for example.

For example, the sensor plate 12 is formed in substantially a rectangular flat plate shape in an XY-planar view and is detachably placed on the upper surface of the well plate 10. That is, the sensor plate 12 is disposed between the head part 26 and the well plate 10. For the sake of convenience of description, in FIG. 2, illustration of a plurality of opening parts 42 (which will be described below) and the like of the sensor plate 12 is omitted. A specific constitution of the sensor plate 12 will be described below.

The discharge unit 8 is a unit for discharging droplets toward one or more wells 24 of the plurality of wells 24 of the well plate 10 and is disposed inside the housing 4. A method in which the discharge unit 8 discharges droplets is a so-called inkjet method in which mist-like droplets are discharged. As shown in FIG. 2, the discharge unit 8 has the head part 26 (an example of a discharge part), and a drive mechanism 28 for driving the head part 26. Driving of the discharge unit 8 is controlled by the control board 64 disposed inside the housing 4.

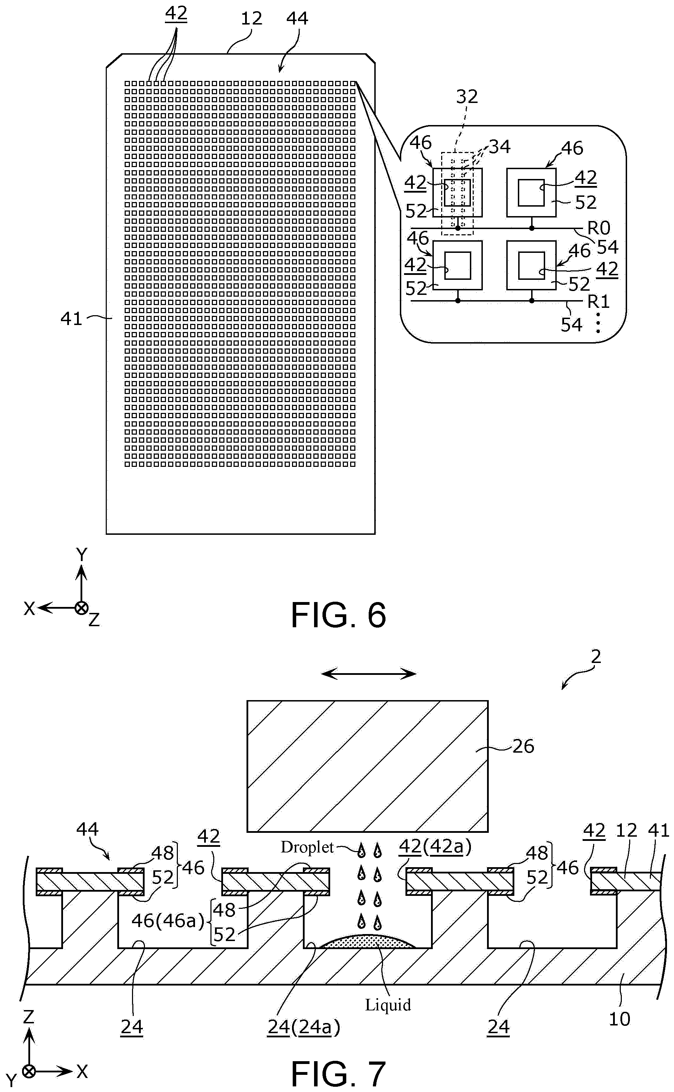

The head part 26 has a carriage 30 and a cartridge 32 detachably attached to the carriage 30. The inside of the cartridge 32 is filled with droplets. As shown in FIG. 6 which will be described below, a plurality of fine nozzles 34 are disposed on a lower surface of the cartridge 32. The plurality of nozzles 34 are disposed side by side in the forward-rearward direction (an example of a predetermined direction) of the cartridge 32. In a state where the cartridge 32 is attached to the carriage 30, the plurality of nozzles 34 are exposed from a lower end part of the carriage 30. The head part 26 discharges droplets, which have been supplied from the plurality of nozzles 34 of the cartridge 32, downward toward the well plate 10 placed in the tray 18 at the storage position.

The drive mechanism 28 is a mechanism reciprocally moving the head part 26 in a predetermined scanning direction (X axis direction). As shown in FIG. 2, the drive mechanism 28 has a guide shaft 36, a carrier motor 38, and a timing belt 40.

The guide shaft 36 is supported by the base plate 16 inside the housing 4 and extends in an elongated shape in the predetermined scanning direction. The carriage 30 of the head part 26 is movably supported by the guide shaft 36. For example, the carrier motor 38 is constituted of a servomotor and is supported by the base plate 16 inside the housing 4. A drive force of the carrier motor 38 is transmitted to the head part 26 via the timing belt 40. Accordingly, the head part 26 reciprocally moves in the predetermined scanning direction along the guide shaft 36 with respect to the well plate 10 placed in the tray 18 at the storage position. That is, the carrier motor 38 moves the head part 26 relatively to the tray 18 in the lateral direction.

In the droplet dispensing device 2 described above, in a state where the well plate 10 is placed on the upper surface of the tray 18 and the sensor plate 12 is placed on the upper surface of the well plate 10, the head part 26 reciprocally moves in the predetermined scanning direction while the tray 18 moves toward the drawn-out position from the storage position, and therefore droplets are discharged toward the well plate 10 from the head part 26. Accordingly, droplets are stored in each of the plurality of wells 24 of the well plate 10 by a predetermined amount (for example, an amount in picoliter order), and droplets are dispensed to the well plate 10. Droplets may be collectively dispensed into each of several to more than ten wells 24, for example, by discharging them once from the head part 26 or may be dispensed into only a single well 24.

[2. Constitution of sensor plate]

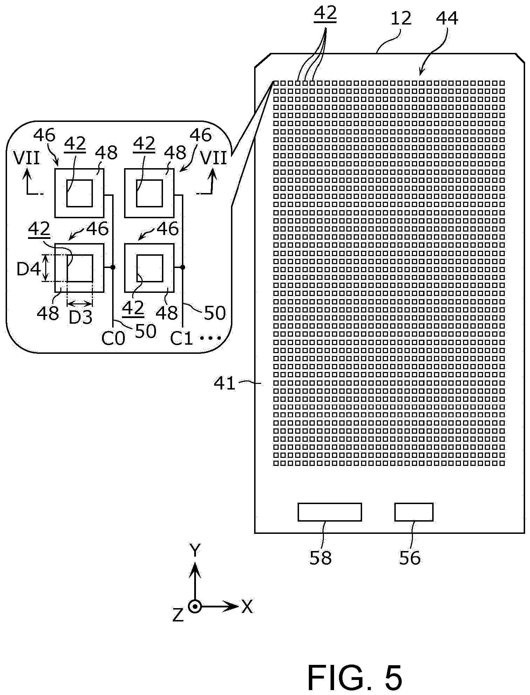

Next, with reference to FIGS. 5 to 7, a constitution of the sensor plate 12 will be described. FIG. 5 is a plan view showing an upper surface side of the sensor plate 12 of the droplet dispensing device 2 according to Embodiment 1. FIG. 6 is a plan view showing a lower surface side of the sensor plate 12 of the droplet dispensing device 2 according to Embodiment 1. FIG. 7 is a cross-sectional view of a main part of the sensor plate 12 according to Embodiment 1 along line VII-VII in FIG. 5.

As shown in FIGS. 5 and 6, the sensor plate 12 has a plate main body 41. For example, the plate main body 41 is formed in substantially a rectangular flat plate shape in an XY-planar view and is formed of a resin or the like. In the plate main body 41, the plurality of opening parts 42 are formed respectively corresponding to the plurality of wells 24 of the well plate 10 in a matrix shape (for example, 32 columns × 48 rows). That is, the plurality of opening parts 42 respectively correspond to the plurality of wells 24 on a one-to-one basis, and the number of opening parts 42 formed in one sensor plate 12 is 1,536 (=32×48), for example, which is the same as the number of wells 24. For example, each of the plurality of opening parts 42 is a penetration hole which is formed in a rectangular shape in an XY-planar view and penetrates the plate main body 41 in a thickness direction (Z axis direction).

The plurality of opening parts 42 are respectively disposed immediately above the plurality of corresponding wells 24. Specifically, when the sensor plate 12 is viewed in a XY planar view, the size (area) of each of the plurality of opening parts 42 is smaller than the size (area) of each of the plurality of wells 24, and the contour of each of the plurality of opening parts 42 is disposed on the inward side of the contour of each of the plurality of wells 24. In an XY-planar view, a transverse (X axis direction) length D3 of each of the opening parts 42 is 1.0 mm (<D1), for example, and a vertical (Y axis direction) length D4 of each of the opening parts 42 is 1.0 mm (<D2), for example. As shown in FIG. 7, an outer circumferential part of the opening part 42 protrudes in a ring shape and an eave shape on the inward side of the well 24 throughout the whole circumference of the well 24. Accordingly, droplets from the head part 26 pass through the opening parts 42 of the sensor plate 12 and are discharged toward the wells 24 immediately below the opening parts 42. For the sake of convenience of description, in FIG. 2 described above, illustration of the plurality of opening parts 42 and the like is omitted.

The sensor plate 12 further has an electrostatic capacitance sensor array 44 in which a plurality of electrostatic capacitance sensors 46 are disposed in an array shape. Each of the plurality of electrostatic capacitance sensors 46 includes first electrodes 48 and second electrodes 52.

As shown in FIGS. 5 and 7, each of a plurality of first electrodes 48 is disposed at a circumferential edge of each of the plurality of opening parts 42 on an upper surface (that is, a surface on a side opposite to the well plate 10, an example of a first main surface) of the plate main body 41. For example, each of the plurality of first electrodes 48 is formed of a copper foil or the like and is formed in a rectangular ring shape in an XY-planar view, for example, such that the whole circumference of the opening part 42 is surrounded.

The plurality of first electrodes 48 are disposed respectively corresponding to the plurality of opening parts 42 in a matrix shape (for example, 32 columns × 48 rows). That is, the plurality of first electrodes 48 form a plurality of columns Ci (i=0, 1, and so on to 32) and a plurality of rows Rj (j=0, 1, and so on to 48) in directions orthogonal to each other. As shown in FIG. 5, the plurality of first electrodes 48 which belong to the same column Ci are electrically connected to each other through a conductive pattern 50 formed of a copper foil or the like.

In addition, as shown in FIGS. 6 and 7, each of a plurality of second electrodes 52 is disposed at the circumferential edge of each of the plurality of opening parts 42 on a lower surface (that is, a surface on a side facing the well plate 10, an example of a second main surface) of the plate main body 41. For example, each of the plurality of second electrodes 52 is formed of a copper foil or the like and is formed in a rectangular ring shape in an XY-planar view, for example, such that the whole circumference of the opening part 42 is surrounded.

The plurality of second electrodes 52 are disposed respectively corresponding to the plurality of opening parts 42 in a matrix shape (for example, 32 columns × 48 rows). That is, the plurality of second electrodes 52 form a plurality of columns Ci (i=0, 1, and so on to 32) and a plurality of rows Rj (j=0, 1, and so on to 48) in directions orthogonal to each other. As shown in FIG. 6, the plurality of second electrodes 52 which belong to the same row Rj are electrically connected to each other through a conductive pattern 54 formed of a copper foil or the like.

The first electrode 48 and the second electrode 52 disposed with respect to the same one opening part 42 are disposed such that they face each other in the thickness direction of the plate main body 41. A pair of the first electrode 48 and the second electrode 52 are electrically insulated.

As shown in FIG. 5, the sensor plate 12 further has a sensor controller 56 (an example of a drive circuit) and a power supply part 58. The sensor controller 56 drives the electrostatic capacitance sensor array 44. The power supply part 58 supplies drive power to the sensor controller 56.

[3. Functional constitution of droplet dispensing device]

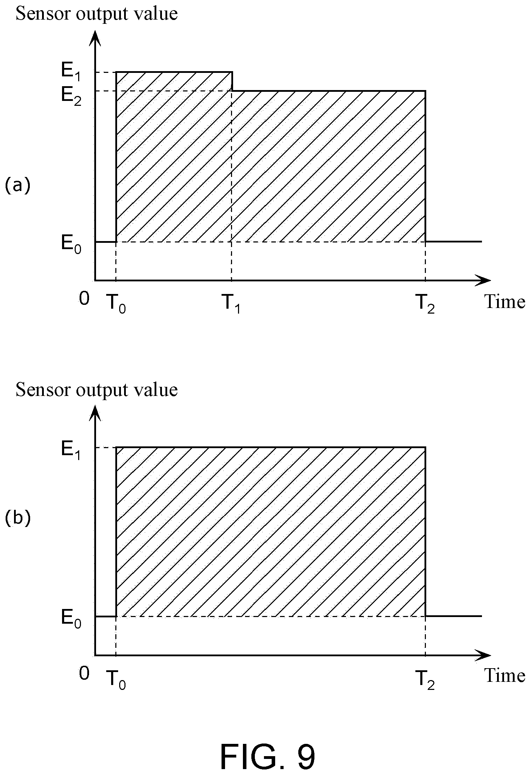

Next, with reference to FIGS. 8 and 9, a functional constitution of the droplet dispensing device 2 according to Embodiment 1 will be described. FIG. 8 is a block diagram showing a functional constitution of the droplet dispensing device 2 according to Embodiment 1. FIG. 9 is a graph showing an example of change over time in electrical signal according to Embodiment 1.

As shown in FIG. 8, the sensor plate 12 has the electrostatic capacitance sensor array 44, the sensor controller 56, the power supply part 58, and a converter 60 as functional constituents.

The sensor controller 56 drives each of the plurality of electrostatic capacitance sensors 46 of the electrostatic capacitance sensor array 44 on the basis of drive power from the power supply part 58. Specifically, the sensor controller 56 applies a drive voltage to the first electrode 48 of each of the plurality of electrostatic capacitance sensors 46 based on drive power from the power supply part 58.

When droplets from the head part 26 are discharged to one or a plurality of wells 24, the sensor controller 56 may selectively drive one or a plurality of electrostatic capacitance sensors 46 corresponding to the one or the plurality of wells 24. In addition, in the present embodiment, the sensor controller 56 applies a drive voltage to the first electrode 48 of each of the plurality of electrostatic capacitance sensors 46, but the embodiment is not limited to this, and a drive voltage may be applied to the second electrode 52 of each of the plurality of electrostatic capacitance sensors 46.

In addition, the sensor controller 56 controls ON and OFF of a static eliminating switch 62. The static eliminating switch 62 is disposed between the electrostatic capacitance sensor array 44 and the ground. When the sensor controller 56 turns on the static eliminating switch 62, the electrostatic capacitance sensor array 44 is grounded via the static eliminating switch 62. Accordingly, electric charge on the electrostatic capacitance sensor array 44 can be caused to flow to the ground via the static eliminating switch 62.

Each of the plurality of electrostatic capacitance sensors 46 outputs an electrical signal which changes in response to change in electrostatic capacitance caused by droplets from the head part 26 having passed through the opening part 42 corresponding to the electrostatic capacitance sensor 46. That is, each of the plurality of electrostatic capacitance sensors 46 detects change in amount of droplets which has passed through the opening part 42 on the basis of change in electrostatic capacitance caused by droplets from the head part 26 having passed through the opening part 42 corresponding to the electrostatic capacitance sensor 46.

The converter 60 performs analog-digital conversion of an electrical signal from each of the plurality of electrostatic capacitance sensors 46. The converter 60 outputs an electrical signal subjected to analog-digital conversion to the control board 64.

For example, the converter 60 outputs an electrical signal as shown in (a) and (b) of FIG. 9. In (a) and (b) of FIG. 9, the horizontal axis represents the time, and the vertical axis represents the value of an electrical signal (which will hereinafter be referred to as "a sensor output value"). The graph shown in (a) of FIG. 9 is an example of change over time in electrical signal when clogging has occurred in the nozzles 34 during discharging of droplets. The graph shown in (b) of FIG. 9 is an example of change over time in electrical signal when no clogging has occurred in the nozzles 34 during discharging of droplets.

In the example shown in (a) of FIG. 9, in a state before a time $T_0$ at which the head part 26 starts discharging of droplets, the sensor output value is $E_0$ (>0). If the head part 26 starts discharging of droplets at the time $T_0$, the sensor output value rises from $E_0$ to $E_1$. Thereafter, due to occurrence of clogging of the nozzles 34 in the head part 26 at a time $T_1$ during discharging of droplets, the sensor output value falls by approximately 5%, for example, from $E_1$ to $E_2$. Thereafter, if the head part 26 ends discharging of droplets at a time $T_2$, the sensor output value falls from $E_2$ to $E_0$.

In addition, in the example shown in (b) of FIG. 9, in a state before the time $T_0$ at which the head part 26 starts discharging of droplets, the sensor output value is $E_0$. If the head part 26 starts discharging of droplets at the time $T_0$, the sensor output value rises from $E_0$ to $E_1$. Thereafter, droplets are discharged without having clogging of the nozzles 34 in the head part 26, and if the head part 26 ends discharging of droplets at the time $T_2$, the sensor output value falls from $E_1$ to $E_0$.

In the present embodiment, the converter 60 performs analog-digital conversion of an electrical signal from each of the plurality of electrostatic capacitance sensors 46, but the embodiment is not limited to this, and an electrical signal from each of the plurality of electrostatic capacitance sensors 46 may be processed as an analog electrical signal. Specifically, for example, the converter 60 may accumulate an electrical signal from each of the plurality of electrostatic capacitance sensors 46 as an analog electrical signal using a low-pass filter, a sample hold circuit, a charge pump circuit, or the like (not shown) and may output the accumulation amount thereof as a voltage. In this case, the converter 60 may further perform analog-digital conversion as necessary. A detection system having a higher sensitivity can be constituted using an analog electrical signal in this manner.

Returning to FIG. 8, the control board 64 has as functional constituents a determination part 66, a discharge control part 68, a movement control part 70, and a notification part 72.

The determination part 66 determines whether a predetermined amount of droplets has passed through a particular opening part 42a of the plurality of opening parts 42 corresponding to a particular electrostatic capacitance sensor 46a (refer to FIG. 7) of the plurality of electrostatic capacitance sensors 46 on the basis of an electrical signal output from the particular electrostatic capacitance sensor 46a (refer to FIG. 7) via the converter 60. The particular opening part 42a is disposed correspondingly to a particular well 24a (refer to FIG. 7) of the plurality of wells 24.

Specifically, in the example shown in (a) of FIG. 9, during the times $T_0$ to $T_1$, the determination part 66 calculates the difference ($E_1$ to $E_0$) between the sensor output value $E_0$ in a state before the head part 26 discharges droplets and the sensor output value $E_1$ in a state where the head part 26 is discharging droplets. In addition, during the times $T_1$ to $T_2$, the determination part 66 calculates the difference ($E_2$ to $E_0$) between the sensor output value $E_0$ and the sensor output value $E_2$ in a state where the head part 26 is discharging droplets. Further, the determination part 66 calculates an integral value by integrating the difference with respect to the period of time ($T_0$ to $T_2$). This integral value corresponds to the area of the region subjected to hatching in (a) of FIG. 9. Further, the determination part 66 determines whether a predetermined amount of droplets has passed through the particular opening part 42a by comparing the calculated integral value and a first threshold.

Here, the first threshold is a target value for determining whether a predetermined amount of droplets has passed through the particular opening part 42a. For example, the first threshold is calculated by the following Expression 1.

First threshold = [{(expected sensor output value in a state where droplets are being discharged) - α × (averaged sensor output value $E_0$ in a state before droplets are discharged)} × (time $T_2$-time $T_0$)]    (expression 1)

In the foregoing Expression 1, the averaged sensor output value $E_0$ in a state before droplets are discharged is multiplied by a certain magnification α (for example, 1.05 times) in consideration of an influence of noise or the like. The averaged sensor output value $E_0$ in a state before droplets are discharged may be a value acquired before a first dispensing operation or may be a value updated every time a dispensing operation is performed. In a case of using a value updated every time a dispensing operation is performed, since it is updated with an appropriate value when the sensor output value $E_0$ fluctuates due to adhesion of droplets or the like, more accurate results can be obtained.

Alternatively, in place of the averaged sensor output value $E_0$ in a state before droplets are discharged, it may be a fixed value of a value obtained by multiplying the largest value of the sensor output value $E_0$ in a state before droplets are discharged by a certain magnification (for example, 1.05 times), which is assumed from the dynamic range of the sensor or electrical characteristics of the circuit. In this case, it is desirable that the value of the magnification be able to be suitably changed depending on the dynamic range of an obtained sensor output, the noise level of the circuit, or the like, and it is possible to consider setting methods such as determining a magnification as a default value in advance, or inputting it as a parameter by a user when operated.

In the example shown in (a) of FIG. 9, since the calculated integral value is smaller than the first threshold, the determination part 66 determines that a predetermined amount of droplets has not passed through the particular opening part 42a. In this case, the determination part 66 instructs the discharge control part 68 such that droplets corresponding to the amount of shortage are discharged from the head part 26 through the particular opening part 42a.

In addition, in the example shown in (b) of FIG. 9, during the time $T_0$ to $T_2$, the determination part 66 calculates the difference ($E_1$ to $E_0$) between the sensor output value $E_0$ in a state before the head part 26 discharges droplets and the sensor output value $E_1$ in a state where the head part 26 is discharging droplets. Further, the determination part 66 calculates an integral value by integrating the difference with respect to the period of time ($T_0$ to $T_2$). This integral value corresponds to the area of the region subjected to hatching in (b) of FIG. 9. Further, the determination part 66 determines whether a predetermined amount of droplets has passed through the particular opening part 42a by comparing the calculated integral value and the first threshold. In the example shown in (b) of FIG. 9, since the calculated integral value is equivalent to the first threshold, the determination part 66 determines that a predetermined amount of droplets has passed through the particular opening part 42a.

As described above, the determination part 66 determines whether a predetermined amount of droplets has passed through the particular opening part 42a by comparing the calculated integral value and the first threshold. This utilizes the fact that there is a correlation between an electrical signal output from the particular electrostatic capacitance sensor 46a via the converter 60 and projection of the volume of droplets passing through the particular opening part 42a. Hereinafter, this will be described.

Regarding an aggregation of droplets passing through the particular opening part 42a as a columnar solid (which will hereinafter be referred to as "a liquid column") having an even cross-sectional area in which the dielectric constant is evenly distributed, change over time in cross-sectional area of the liquid column is considered. At this time, since the rate of change in cross-sectional area and the rate of change in dielectric constant are proportional to each other, it is possible to equivalently catch change in amount of droplets passing through the particular opening part 42a by observing the change in sensor output value per unit time.

Here, when the depth of the particular opening part 42a is D, the cross-sectional area of the liquid column at a distance d (0<d<D) from the upper surface of the plate main body 41 is expressed as S(t, d) as a function of a time t after discharging of droplets from the head part 26 has started and the distance d. At this time, the amount of discharged droplets during a minute period of time Δt at the distance d and the time t is expressed as S(t, d)×Δt, and the volume V(t) of droplets present in the particular opening part 42a can be obtained by the following Expression 2.

$$V(t) = \int_{d=0}^{d=D} S(t,d) \cdot dt = \sum_{d=0}^{D} S(t,d) \cdot \Delta t \quad \text{(Expression 2)}$$

In addition, as shown in the following Expression 3, change in electrostatic capacitance Ci in the region occupied by the liquid columns in the particular opening part 42a indicates fluctuation according to change in cross-sectional area $S_1$, that is, volume of the liquid columns. Meanwhile, as shown in the following Expression 4, an electrostatic capacitance $C_2$ in the region occupied by air in the particular opening part 42a indicates fluctuation according to change in cross-sectional area $S_2$, that is, volume of the liquid columns. As a result, a resultant capacitance C of the electrostatic

capacitances $C_1$ and $C_2$ is indicated by the following Expression 5, and it is possible to estimate change in cross-sectional area $S_1$, that is, change in volume of droplets present in the particular opening part 42a on the basis of an electrical signal from the particular electrostatic capacitance sensor 46a.

$$C_1 = \varepsilon_0 \varepsilon_1 \frac{S_1}{D} \quad \text{(Expression 3)}$$

$$C_2 = \varepsilon_0 \varepsilon_2 \frac{S_2}{D} \quad \text{(Expression 4)}$$

$$C = C_1 + C_2 = \frac{\varepsilon_0}{D}(\varepsilon_1 S_1 + \varepsilon_2 (S_0 - S_1)) \quad \text{(Expression 5)}$$

$\varepsilon_0$: dielectric constant in vacuum
$\varepsilon_1$: dielectric constant of droplets
$\varepsilon_2$: dielectric constant of air
$S_0$: cross-sectional area of opening parts
$S_1$: cross-sectional area of region filled with droplets in opening parts
$S_2$: cross-sectional area of region filled with air in opening parts

In addition, the total discharging amount $V_{amount}$ of droplets during a period of time $T_{disp}$ from start to end of discharging of droplets is obtained by the following Expression 6.

$$V_{amount} = \frac{\int_{t=0}^{T_{disp}} V(t) \cdot dt}{T_{disp}} = \frac{\sum_{t=0}^{T_{disp}} V(t) \cdot \Delta t}{T_{disp}} \quad \text{(Expression 6)}$$

Returning to FIG. 8, the discharge control part 68 controls discharging of droplets from the head part 26 of the discharge unit 8 on the basis of an instruction from the determination part 66.

The movement control part 70 controls driving of the carrier motor 38 of the discharge unit 8 and driving of the tray motor 20 on the basis of an instruction from the determination part 66.

When the sensor output value $E_0$ in a state before the head part 26 discharges droplets exceeds a second threshold, the notification part 72 issues a notification for prompting a user to perform maintenance (for example, cleaning, replacement, or the like) of the sensor plate 12 on the basis of an instruction from the determination part 66.

The second threshold is a threshold for determining degradation in accuracy of calculating a predetermined amount of droplets due to droplets which have adhered to the lower surface of the plate main body 41 of the sensor plate 12. For example, the second threshold is determined as follows. With the averaged sensor output value $E_0$ in a state before droplets are discharged, a value obtained by multiplying this $E_0$ by a certain magnification (for example, 1.05 times) can be adopted as the second threshold. Alternatively, the second threshold may be a fixed value of a value obtained by multiplying the largest value of the sensor output value $E_0$ in a state before droplets are discharged by a certain magnification (for example, 1.05 times), which is assumed from the dynamic range of sensor characteristics or electrical characteristics of the circuit. In this case, it is desirable that the value of the magnification be able to be suitably changed depending on the dynamic range of an obtained sensor output, the noise level of the circuit, or the like, and it is possible to consider setting methods such as determining a magnification as a default value in advance, or inputting it as a parameter by a user when operated. In addition, in determining the second threshold, an offset may be added or subtracted in addition to multiplying the sensor output value $E_0$ by a certain magnification. A DC component of the circuit can be canceled by adding or subtracting an offset, so that it can be accurately determined.

Here, when the sensor output value $E_0$ exceeds the second threshold, since there is a probability that droplets which have bounced off bottom parts of the wells 24 will have adhered to the lower surface of the plate main body 41 of the sensor plate 12, there is concern that determination accuracy of the determination part 66 is degraded. For this reason, the notification part 72 issues the foregoing notification in such a case so that a user can be prompted to perform maintenance of the sensor plate 12. For example, the notification part 72 may cause a display (not shown) disposed in the housing 4 to display contents of notification, or contents of notification may be transmitted to a terminal device such as a smartphone or a personal computer used by a user.

[4. Operation of droplet dispensing device]

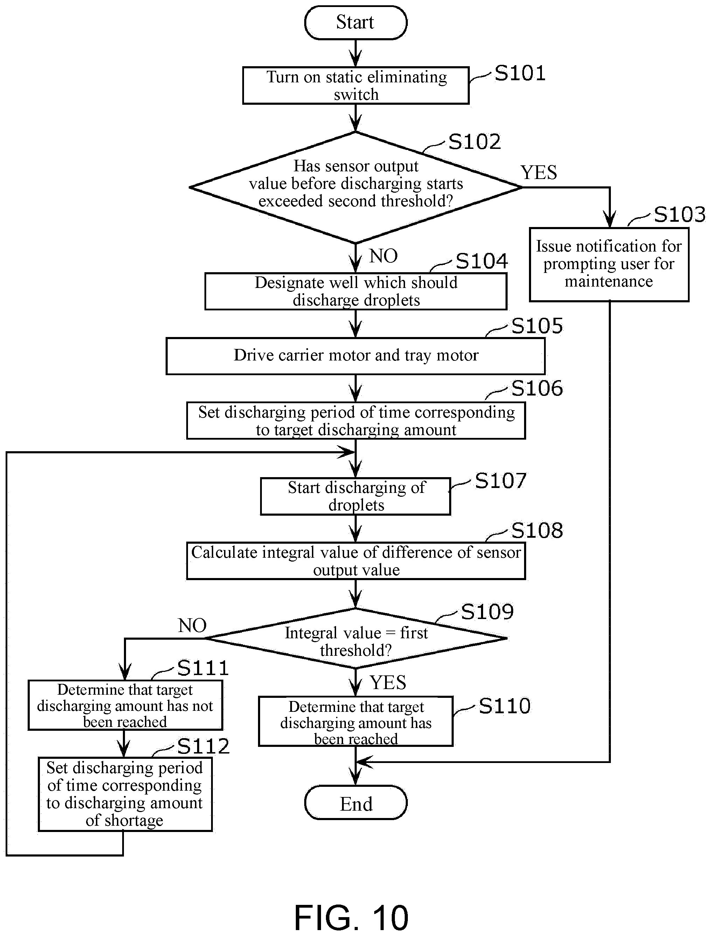

Next, with reference to FIG. 10, operation of the droplet dispensing device 2 according to Embodiment 1 will be described. FIG. 10 is a flowchart showing a flow of operation of the droplet dispensing device 2 according to Embodiment 1.

Hereinafter, a case of discharging a predetermined amount of droplets from the head part 26 (which will hereinafter be referred to as "a target discharging amount") to the particular well 24a through the particular opening part 42a will be described.

As shown in FIG. 10, first, the sensor controller 56 turns on the static eliminating switch 62 on the basis of an instruction from the determination part 66 (S101). Accordingly, electric charge on the electrostatic capacitance sensor array 44 flows to the ground via the static eliminating switch 62, and therefore the electrostatic capacitance sensor array 44 is statically eliminated.

Next, the determination part 66 determines whether the sensor output value in a state before the head part 26 discharges droplets has exceeded the second threshold (S102). When the sensor output value has exceeded the second threshold (YES in S102), the determination part 66 outputs an instruction to the notification part 72. Accordingly, the notification part 72 issues a notification for prompting a user to perform maintenance of the sensor plate 12 on the basis of an instruction from the determination part 66 (S103). Thereafter, the processing of the flowchart in FIG. 10 ends.

Returning to Step S102, when the sensor output value is equal to or smaller than the second threshold (NO in S102), the determination part 66 designates the particular well 24a which should discharge droplets (S104) and outputs an instruction to the movement control part 70. Accordingly, the movement control part 70 drives the carrier motor 38 and the tray motor 20 on the basis of an instruction from the determination part 66 such that the head part 26 is positioned immediately above the particular well 24a (S105).

Next, the determination part 66 sets the discharging period of time $T_{disp}$ corresponding to a target discharging amount (S106) and outputs an instruction to the discharge control part 68. Next, the discharge control part 68 controls the head part 26 on the basis of an instruction from the determination part 66 such that discharging of droplets starts (S107). Accordingly, droplets from the head part 26 are discharged to the particular well 24a through the particular opening part 42a over the discharging period of time $T_{disp}$. At this time, the electrostatic capacitance changes due to droplets passing through the particular opening part 42a. The particular electrostatic capacitance sensor 46a outputs an electrical signal which changes in response to change in electrostatic capacitance during the discharging period of time $T_{disp}$.

At a timing when discharging of droplets ends after the discharging period of time $T_{disp}$ has elapsed, the determination part 66 calculates the difference between the sensor output value in a state before the head part 26 discharges droplets and the sensor output value in a state where the head part 26 is discharging droplets and calculates an integral value by integrating the difference with respect to the period of time (S108). Next, the determination part 66 determines whether the calculated integral value is equivalent to the first threshold (S109).

When the integral value is equivalent to the first threshold (YES in S109), the determination part 66 determines that the target discharging amount of droplets has passed through the particular opening part 42a, that is, the discharging amount of droplets from the head part 26 has reached the target discharging amount (S110). Thereafter, the processing of the flowchart in FIG. 10 ends.

Returning to Step S109, when the integral value is smaller than the first threshold (NO in S109), the determination part 66 determines that the target discharging amount of droplets has not passed through the particular opening part 42a, that is, the discharging amount of droplets from the head part 26 has not reached the target discharging amount (Sill). In this case, the determination part 66 sets a discharging period of time $T'_{disp}$ ($<T_{disp}$) according to droplets corresponding to the amount of shortage (S112), an instruction is output to the discharge control part 68, and the processing returns to Step S107 described above.

Next, the discharge control part 68 controls the head part 26 on the basis of an instruction from the determination part 66 such that discharging of droplets starts (S107). Accordingly, droplets from the head part 26 corresponding to the amount of shortage are discharged to the particular well 24a through the particular opening part 42a over the discharging period of time $T'_{disp}$. Thereafter, until the discharging amount of droplets from the head part 26 reaches the target discharging amount, Steps S107 to S112 described above are repeatedly executed.

[5. Effects]

The particular electrostatic capacitance sensor 46a detects change in amount of droplets from the head part 26 having passed through the particular opening part 42a on the basis of change in electrostatic capacitance caused by droplets which have passed through the particular opening part 42a corresponding to the particular electrostatic capacitance sensor 46a.

Accordingly, for example, on the basis of detection results of the particular electrostatic capacitance sensor 46a, it is possible to determine whether a predetermined amount of droplets has passed through the particular opening part 42a. When the discharging amount of droplets does not reach a predetermined amount due to clogging or the like of the nozzles 34 in the head part 26, processing such as discharging droplets from the head part 26 corresponding to the amount of shortage can be executed. As a result, droplets can be accurately dispensed to the well plate 10.

(Embodiment 2)

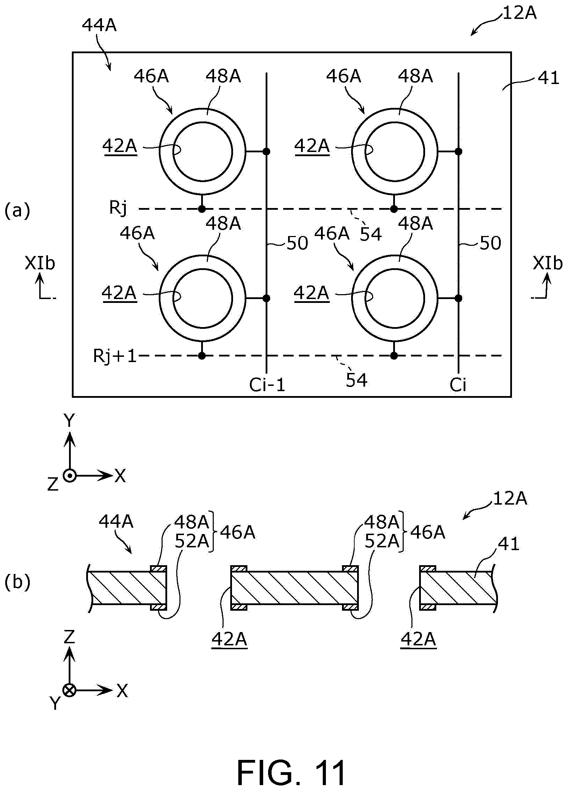

With reference to FIG. 11, a constitution of a sensor plate 12A according to Embodiment 2 will be described. FIG. 11 is a view showing the sensor plate 12A according to Embodiment 2. Specifically, (a) of FIG. 11 is an enlarged plan view showing a portion of the sensor plate 12A according to Embodiment 2, and (b) of FIG. 11 is a cross-sectional view of a main part of the sensor plate 12A along line XIB-XIB in (a) of FIG. 11. In each of the embodiments which will be described below, the same reference signs are applied to constituent elements which are the same as those in the foregoing Embodiment 1, and description thereof will be omitted.

In the sensor plate 12A according to Embodiment 2, the shape of each of a plurality of opening parts 42A differs from that in the foregoing Embodiment 1. Specifically, as shown in (a) of FIG. 11, each of the plurality of opening parts 42A is formed in a circular shape in an XY-planar view.

In addition, in the sensor plate 12A according to Embodiment 2, the shape of each of a plurality of electrostatic capacitance sensors 46A in an electrostatic capacitance sensor array 44A differs from that in the foregoing Embodiment 1. Specifically, as shown in (a) and (b) of FIG. 11, each of a plurality of first electrodes 48A is formed in a circular ring shape in an XY-planar view such that the whole circumference of the opening part 42A is surrounded. In addition, each of a plurality of second electrodes 52A is formed in a circular ring shape in an XY-planar view such that the whole circumference of the opening part 42A is surrounded.

Even with a constitution like the sensor plate 12A according to Embodiment 2, effects similar to those in the foregoing Embodiment 1 can be achieved.

(Embodiment 3)

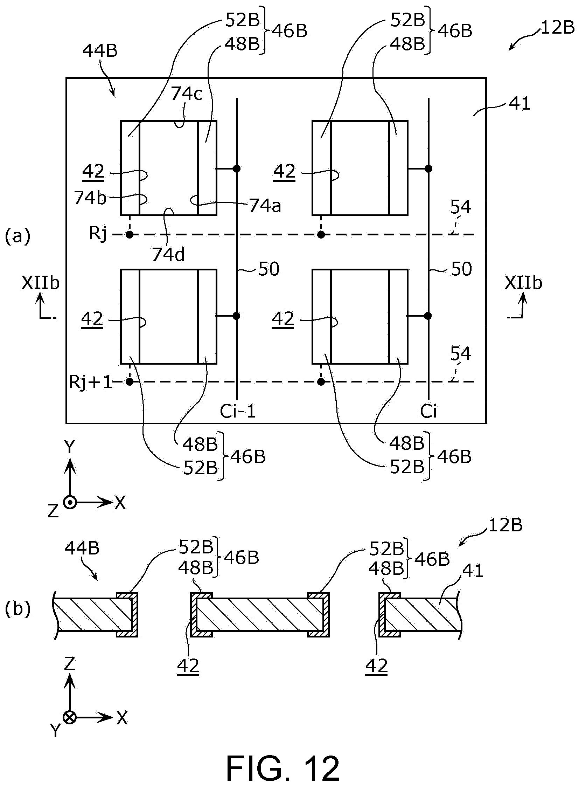

With reference to FIG. 12, a constitution of a sensor plate 12B according to Embodiment 3 will be described. FIG. 12 is a view showing the sensor plate 12B according to Embodiment 3. Specifically, (a) of FIG. 12 is an enlarged plan view showing a portion of the sensor plate 12B according to Embodiment 3, and (b) of FIG. 12 is a cross-sectional view of a main part of the sensor plate 12B along line XIIB-XIIB in (a) of FIG. 12.

In the sensor plate 12B according to Embodiment 3, similar to the foregoing Embodiment 1, each of the plurality of opening parts 42 is formed in a rectangular shape in an XY-planar view. That is, as shown in (a) of FIG. 12, each of the plurality of opening parts 42 has a first side 74a and a second side 74b extending substantially parallel to the forward-rearward direction (Y axis direction) that is a direction in which the nozzles 34 (refer to FIG. 6) are disposed and facing each other, and a third side 74c and a fourth side 74d extending substantially perpendicular to the forward-rearward direction and facing each other.

In addition, in the sensor plate 12B according to Embodiment 3, a constitution of each of a plurality of electrostatic capacitance sensors 46B of an electrostatic capacitance sensor array 44B differs from that in the foregoing Embodiment 1. Specifically, as shown in (a) and (b) of FIG. 12, each of the plurality of electrostatic capacitance sensors 46B includes a first electrode 48B disposed in a region corresponding to the first side 74a at the circumferential edge of the opening part 42 corresponding to the electrostatic capacitance sensor 46B, and a second electrode 52B disposed in a region corresponding to the second side 74b at the circumferential edge of the opening part 42 corresponding to the electrostatic capacitance sensor 46B.

In addition, as shown in (b) of FIG. 12, each of the first electrode 48B and the second electrode 52B extends from the circumferential edge of the opening part 42 on the upper surface of the plate main body 41 to the circumferential edge of the opening part 42 on the lower surface of the plate main body 41 via an inner circumferential surface of the opening part 42.

Even with a constitution like the sensor plate 12B according to Embodiment 3, effects similar to those in the foregoing Embodiment 1 can be achieved.

(Embodiment 4)

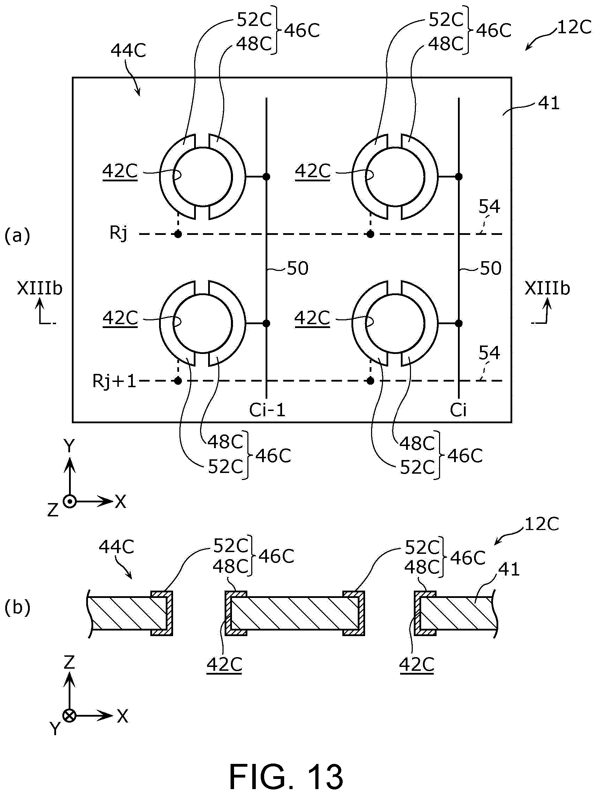

With reference to FIG. 13, a constitution of a sensor plate 12C according to Embodiment 4 will be described. FIG. 13 is a view showing the sensor plate 12C according to Embodiment 4. Specifically, (a) of FIG. 13 is an enlarged plan view showing a portion of the sensor plate 12C according to Embodiment 4, and (b) of FIG. 13 is a cross-sectional view of a main part of the sensor plate 12C along line XIIIB-XIIIB in (a) of FIG. 13.

In the sensor plate 12C according to Embodiment 4, the shape of each of a plurality of opening parts 42C differs from that in the foregoing Embodiment 1. Specifically, as shown in (a) of FIG. 13, each of the plurality of opening parts 42C is formed in a circular shape in an XY-planar view.

In addition, in the sensor plate 12C according to Embodiment 4, a constitution of each of a plurality of electrostatic capacitance sensors 46C of an electrostatic capacitance sensor array 44C differs from that in the foregoing Embodiment 1. Specifically, as shown in (a) and (b) of FIG. 13, each of the plurality of electrostatic capacitance sensors 46C includes a first electrode 48C disposed in an arc shape (substantially a C-shape) along the circumferential edge of the opening part 42C corresponding to the electrostatic capacitance sensor 46C, and a second electrode 52C disposed in an arc shape (substantially a C-shape) along the circumferential edge of the opening part 42C corresponding to the electrostatic capacitance sensor 46C. In an XY-planar view, the first electrode 48C and the second electrode 52C are disposed at positions substantially line-symmetrical with respect to the center of the diameter of the opening part 42C.

In addition, as shown in (b) of FIG. 13, each of the first electrode 48C and the second electrode 52C extends from the circumferential edge of the opening part 42C on the upper surface of the plate main body 41 to the circumferential edge of the opening part 42C on the lower surface of the plate main body 41 via an inner circumferential surface of the opening part 42C.

Even with a constitution like the sensor plate 12C according to Embodiment 4, effects similar to those in the foregoing Embodiment 1 can be achieved.

(Modification)

Hereinabove, the droplet dispensing device and the sensor plate according to each of the embodiments of the disclosure have been described, but the disclosure is not limited to each of the foregoing embodiments.

In each of the foregoing embodiments, the tray 18 is constituted to be able to move between the storage position and the drawn-out position, but the embodiment is not limited to this, and the tray 18 may be fixed to the housing 4. In this case, the drive mechanism 28 may move the head part 26 in triaxial directions, such as in the X axis direction, the Y axis direction, and the Z axis direction.

In addition, in each of the foregoing embodiments, the well plate 10 and the sensor plate 12 (12A, 12B, or 12C) are separately constituted, but the embodiment is not limited to this, and the sensor plate 12 (12A, 12B, or 12C) may be formed integrally with the upper surface of the well plate 10.

[Industrial Applicability]

The disclosure can be applied as a droplet dispensing device or the like for dispensing droplets of a reagent or the like to a well plate, for example.

[Reference Signs List]

2 Droplet dispensing device

4 Housing
6 Tray unit
8 Discharge unit
10 Well plate
12, 12A, 12B, 12C Sensor plate
14, 42, 42A, 42C Opening part
16 Base plate
18 Tray
20 Tray motor
22 Guide plate
24 Well
24a Particular well
26 Head part
28 Drive mechanism
30 Carriage

32 Cartridge
34 Nozzle
36 Guide shaft
38 Carrier motor
40 Timing belt
41 Plate main body
42a Particular opening part
44, 44A, 44B, 44C Electrostatic capacitance sensor array
46, 46A, 46B, 46C Electrostatic capacitance sensor
46a Particular electrostatic capacitance sensor
48, 48A, 48B, 48C First electrode
50, 54 Conductive pattern
52, 52A, 52B, 52C Second electrode
56 Sensor controller
58 Power supply part
60 Converter
62 Static eliminating switch
64 Control board
66 Determination part
68 Discharge control part
70 Movement control part
72 Notification part
74a First side
74b Second side
74c Third side
74d Fourth side

## Claims

1. A droplet dispensing device (2) for dispensing droplets to a well plate (10) having a plurality of wells (24, 24a) formed on a main surface thereof, the droplet dispensing device (2) comprising:

   a discharge part (26) discharging droplets toward one or more wells (24, 24a) of the plurality of wells (24, 24a); and
   a sensor plate (12, 12A, 12B, 12C) disposed between the discharge part (26) and the well plate (10), the sensor plate (12, 12A, 12B, 12C) having a plurality of opening parts (14, 42, 42a, 42A, 42C) formed respectively corresponding to the plurality of wells (24, 24a) and a plurality of electrostatic capacitance sensors (46, 46a, 46A, 46B, 46C) each disposed at a circumferential edge of the plurality of opening parts (14, 42, 42a, 42A, 42C).

2. The droplet dispensing device (2) according to claim 1,
   wherein each of the plurality of electrostatic capacitance sensors (46, 46a, 46A, 46B, 46C) detects droplets from the discharge part (26) having passed through an opening part (14, 42, 42a, 42A, 42C) on the basis of change in electrostatic capacitance caused by the droplets which have passed through the opening part (14, 42, 42a, 42A, 42C), of the plurality of opening parts (14, 42, 42a, 42A, 42C), corresponding to the electrostatic capacitance sensor (46, 46a, 46A, 46B, 46C).

3. The droplet dispensing device (2) according to claim 2,

   wherein each of the plurality of electrostatic capacitance sensors (46, 46a, 46A, 46B, 46C) outputs an electrical signal changing in response to the change in electrostatic capacitance, and
   the droplet dispensing device (2) further comprises a determination part (66) determining whether a predetermined amount of droplets has passed through a particular opening part (42a) of the plurality of opening parts (14, 42, 42a, 42A, 42C) corresponding to a particular electrostatic capacitance sensor (46a) of the plurality of electrostatic capacitance sensors (46, 46a, 46A, 46B, 46C) on the basis of an electrical signal from the particular electrostatic capacitance sensor (46a).

4. The droplet dispensing device (2) according to claim 3,
   wherein the determination part (66) determines whether the predetermined amount of droplets has passed through the particular opening part (42a) by calculating a difference between a value of an electrical signal from the particular electrostatic capacitance sensor (46a) in a state before the discharge part (26) discharges droplets and a value of an electrical signal from the particular electrostatic capacitance sensor (46a) in a state where the discharge part (26) is discharging droplets, and comparing an integral value obtained by integrating the difference with respect to time with a first threshold.

5. The droplet dispensing device (2) according to claim 3,

   wherein the droplet dispensing device (2) further comprises a converter (60) performing analog-digital conversion of an electrical signal from each of the plurality of electrostatic capacitance sensors (46, 46a, 46A, 46B, 46C), and the determination part (66) determines whether the predetermined amount of droplets has passed through the particular opening part (42a) on the basis of an electrical signal from the particular electrostatic capacitance sensor (46a) subjected to analog-digital conversion by the converter (60).

6. The droplet dispensing device (2) according to claim 3,

   wherein the droplet dispensing device (2) further comprises a converter (60) accumulating an electrical signal from each of the plurality of electrostatic capacitance sensors (46, 46a, 46A, 46B, 46C) as an analog electrical signal, and the determination part (66) determines whether the predetermined amount of droplets has passed through the particular opening part (42a) on the basis of an electrical signal from the particular electrostatic capacitance sensor (46a) accumulated by the converter (60).

7. The droplet dispensing device (2) according to claim 3,
   wherein the determination part (66) further controls the discharge part (26) such that droplets corresponding to an amount of shortage are discharged through the particular opening part (42a) in response to determination that the predetermined amount of droplets has not passed through the particular opening part (42a).

8. The droplet dispensing device (2) according to claim 3,
   wherein the droplet dispensing device (2) further comprises a notification part (72) issuing a notification for prompting a user to perform maintenance of the sensor plate (12, 12A, 12B, 12C) in response to a value of an electrical signal from the particular electrostatic capacitance sensor (46a) in a state before the discharge part (26) discharges droplets exceeding a second threshold.

9. The droplet dispensing device (2) according to claim 1,
   wherein the droplet dispensing device (2) further comprises a drive circuit (56) selectively driving a particular electrostatic capacitance sensor (46a), of the plurality of electrostatic capacitance sensors (46, 46a, 46A, 46B, 46C), corresponding to a particular well (24a) in response to droplets from the discharge part (26) being discharged to the particular well (24a) of the plurality of wells (24, 24a).

10. The droplet dispensing device (2) according to claim 1,
    wherein the sensor plate (12, 12A, 12B, 12C) is formed integrally with an upper surface of the well plate (10).

11. The droplet dispensing device (2) according to any one of claims 1 to 10,

    wherein the discharge part (26) comprises a plurality of nozzles (34) disposed side by side in a predetermined direction,
    each of the plurality of opening parts (14, 42, 42a, 42A, 42C) is formed in a rectangular shape having a first side (74a) and a second side (74b) extending substantially parallel to the predetermined direction and facing each other, and a third side (74c) and a fourth side (74d) extending substantially perpendicular to the predetermined direction and facing each other, and
    each of the plurality of electrostatic capacitance sensors (46, 46a, 46A, 46B, 46C) comprises

    a first electrode (48, 48A, 48B, 48C) disposed in a region corresponding to the first side (74a) at the circumferential edge of the opening part (14, 42, 42a, 42A, 42C) corresponding to the electrostatic capacitance sensor (46, 46a, 46A, 46B, 46C), and
    a second electrode (52, 52A, 52B, 52C) disposed in a region corresponding to the second side (74b) at the circumferential edge of the opening part (14, 42, 42a, 42A, 42C) corresponding to the electrostatic capacitance sensor (46, 46a, 46A, 46B, 46C).

12. The droplet dispensing device (2) according to any one of claims 1 to 10,

   wherein each of the plurality of opening parts (14, 42, 42a, 42A, 42C) is formed in a circular shape, and
   each of the plurality of electrostatic capacitance sensors (46, 46a, 46A, 46B, 46C) comprises

   a first electrode (48, 48A, 48B, 48C) disposed in an arc shape along the circumferential edge of the opening part (14, 42, 42a, 42A, 42C) corresponding to the electrostatic capacitance sensor (46, 46a, 46A, 46B, 46C), and
   a second electrode (52, 52A, 52B, 52C) disposed in an arc shape along the circumferential edge of the opening part (14, 42, 42a, 42A, 42C) corresponding to the electrostatic capacitance sensor (46, 46a, 46A, 46B, 46C) and disposed at a position substantially symmetrical to the first electrode (48, 48A, 48B, 48C) with respect to a center of a diameter of the opening part (14, 42, 42a, 42A, 42C).

13. The droplet dispensing device (2) according to any one of claims 1 to 10,

   wherein each of the plurality of opening parts (14, 42, 42a, 42A, 42C) is formed in a circular shape or a rectangular shape, and
   each of the plurality of electrostatic capacitance sensors (46, 46a, 46A, 46B, 46C) comprises

   a first electrode (48, 48A, 48B, 48C) disposed at the circumferential edge of the opening part (14, 42, 42a, 42A, 42C) corresponding to the electrostatic capacitance sensor (46, 46a, 46A, 46B, 46C) on a first main surface of the sensor plate (12, 12A, 12B, 12C), and
   a second electrode (52, 52A, 52B, 52C) disposed at the circumferential edge of the opening part (14, 42, 42a, 42A, 42C) corresponding to the electrostatic capacitance sensor (46, 46a, 46A, 46B, 46C) on a second main surface on a side opposite to the first main surface of the sensor plate (12, 12A, 12B, 12C).

14. A sensor plate (12, 12A, 12B, 12C) used in a droplet dispensing device (2) having a discharge part (26) discharging droplets toward a well plate (10) having a plurality of wells (24, 24a) formed on a main surface thereof, the sensor plate (12, 12A, 12B, 12C) comprising:

   a plate main body (41) disposed between the discharge part (26) and the well plate (10) and having a plurality of opening parts (14, 42, 42a, 42A, 42C) formed respectively corresponding to the plurality of wells (24, 24a); and
   a plurality of electrostatic capacitance sensors (46, 46a, 46A, 46B, 46C) each disposed at a circumferential edge of the plurality of opening parts (14, 42, 42a, 42A, 42C).

15. A droplet detection method in a droplet dispensing device (2) for dispensing droplets to a well plate (10) having a plurality of wells (24, 24a) formed on a main surface thereof,

   wherein the droplet dispensing device (2) comprises

   a discharge part (26) discharging droplets toward one or more wells (24, 24a) of the plurality of wells (24, 24a), and
   a sensor plate (12, 12A, 12B, 12C) disposed between the discharge part (26) and the well plate (10), the sensor plate (12, 12A, 12B, 12C) having a plurality of opening parts (14, 42, 42a, 42A, 42C) formed respectively corresponding to the plurality of wells (24, 24a) and a plurality of electrostatic capacitance sensors (46, 46a, 46A, 46B, 46C) each disposed at a circumferential edge of the plurality of opening parts (14, 42, 42a, 42A, 42C), and

   in the droplet detection method, droplets from the discharge part (26) having passed through an opening part (14, 42, 42a, 42A, 42C) are detected using each of the plurality of electrostatic capacitance sensors (46, 46a, 46A, 46B, 46C) on the basis of change in electrostatic capacitance caused by the droplets which have passed through the opening part (14, 42, 42a, 42A, 42C), of the plurality of opening parts (14, 42, 42a, 42A, 42C), corresponding to the electrostatic capacitance sensor (46, 46a, 46A, 46B, 46C).

FIG. 1

EP 4 464 414 A1

FIG. 2

FIG. 3

FIG. 4

FIG. 5

FIG. 6

FIG. 7

FIG. 8

EP 4 464 414 A1

FIG. 9

Start

Turn on static eliminating switch — S101

Has sensor output value before discharging starts exceeded second threshold? — S102

YES → Issue notification for prompting user for maintenance — S103

NO — S104
Designate well which should discharge droplets

Drive carrier motor and tray motor — S105

Set discharging period of time corresponding to target discharging amount — S106

Start discharging of droplets — S107

Calculate integral value of difference of sensor output value — S108

Integral value = first threshold? — S109

NO → Determine that target discharging amount has not been reached — S111

Set discharging period of time corresponding to discharging amount of shortage — S112

YES → Determine that target discharging amount has been reached — S110

End

FIG. 10

(a)

44A
12A
46A    48A        46A    48A
41
42A                42A

Rj

46A    48A        46A  54  48A
XIb                            50              50    XIb

42A                42A

Rj+1

Ci-1        54        Ci

Y
Z⊙→X

(b)

44A    48A ⎫46A              48A ⎫46A    12A
52A ⎭                52A ⎭
41
42A                42A

Z
Y⊗→X

# FIG. 11

FIG. 12

FIG. 13

Europäisches
Patentamt

European
Patent Office

Office européen
des brevets

# EUROPEAN SEARCH REPORT

**Application Number**

EP 24 17 0791

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/033634 A1 (BÖLTZ HARRY [DE] ET AL) 4 February 2021 (2021-02-04) * paragraphs [0018] - [0020], [0060] - [0061]; claims 1,6,9,10; figures 1,2 * | 1-15 | INV. B01L3/02 |
| A | US 2004/089825 A1 (SCHWENKE HEINRICH [DE] ET AL) 13 May 2004 (2004-05-13) * paragraphs [0024] - [0033] * | 1-15 | |
| A | JP H07 333231 A (ALOKA CO LTD) 22 December 1995 (1995-12-22) * paragraphs [0017] - [0023]; figure 1 * | 1-15 | |

**TECHNICAL FIELDS SEARCHED (IPC)**

B01L

The present search report has been drawn up for all claims

| Place of search | Date of completion of the search | Examiner |
|---|---|---|
| The Hague | 1 October 2024 | Pessenda García, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 0791

This annex lists the patent family members relating to the patent documents cited in  the above-mentioned European search report.
The members are as contained in the European Patent Office EDP file on
The European Patent Office is in no way liable for these particulars which are merely given for the purpose of information.

01-10-2024

| Patent document cited in search report | | Publication date | Patent family member(s) | | Publication date |
|---|---|---|---|---|---|
| US 2021033634 | A1 | 04-02-2021 | CN | 111699044 A | 22-09-2020 |
| | | | EP | 3520896 A1 | 07-08-2019 |
| | | | JP | 7223767 B2 | 16-02-2023 |
| | | | JP | 2021514462 A | 10-06-2021 |
| | | | KR | 20200118063 A | 14-10-2020 |
| | | | US | 2021033634 A1 | 04-02-2021 |
| | | | WO | 2019149852 A1 | 08-08-2019 |
| US 2004089825 | A1 | 13-05-2004 | DE | 10241545 A1 | 25-03-2004 |
| | | | EP | 1396714 A1 | 10-03-2004 |
| | | | US | 2004089825 A1 | 13-05-2004 |
| JP H07333231 | A | 22-12-1995 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005283150 A